(19)

Europäisches
Patentamt

European
Patent Office

Office européen
des brevets

(11) **EP 4 304 322 A1**

(12) **EUROPEAN PATENT APPLICATION**

(43) Date of publication:
**10.01.2024 Bulletin 2024/02**

(21) Application number: **22183535.8**

(22) Date of filing: **07.07.2022**

(51) International Patent Classification (IPC):
**H10N 60/84** (2023.01)          **H10N 60/01** (2023.01)
**G01J 1/00** (2006.01)             **G01J 1/44** (2006.01)
**G01J 5/20** (2006.01)

(52) Cooperative Patent Classification (CPC):
**H10N 60/84; H10N 60/01; H10N 60/0241;**
**G01J 2001/442; G01J 2005/208**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Technische Universität München**
**80333 München (DE)**

(72) Inventors:
• **Flaschmann, Jan Rasmus**
  **80939 München (DE)**

• **Schmid, Christian**
  **80939 München (DE)**
• **Müller, Kai**
  **85386 Eching (DE)**
• **Zugliani, Lucio**
  **81371 München (DE)**
• **Finley, Jonathan James**
  **85609 Aschheim (DE)**
• **Strohauer, Stefan**
  **80939 München (DE)**
• **Ernst, Sven**
  **86860 Jengen (DE)**

(74) Representative: **Koplin, Moritz**
  **Anne-Conway-Straße 1**
  **28359 Bremen (DE)**

(54) **PHOTON DETECTION**

(57)     Provided is a photon detector and method of manufacturing a photon detector. The method comprises forming an oxide layer (14), forming a superconducting material layer (24a, 24b, 24c), and forming an oxidation barrier layer (16) between, and abutting, the oxide layer and the superconducting material layer.

**Fig. 12**

EP 4 304 322 A1

# Description

FIELD

The present disclosure relates to photon detection. In particular, the present disclosure relates to a method of manufacturing superconducting nanowire single-photon detectors and superconducting nanowire single-photon detectors manufactured in accordance with the method. In addition, the present disclosure relates to a space-efficient design of conducting wires such as superconducting nanowires.

BACKGROUND

As illustrated in US 8,761,848 B2, a superconducting nanowire single-photon detector may comprise a nanowire made of a superconducting material. The nanowire may be arranged in a resonance structure that is configured to trap photons. A trapped photon may interact with the nanowire, thereby causing the formation of a localized non-superconducting region. The formation of the localized non-superconducting region may then be detected based on an increase in electrical resistance of the nanowire.

SUMMARY

The present invention is directed at a photon detector, a method of manufacturing a photon detector, and a conducting wire.

The method comprises forming a first oxide layer, forming a superconducting material layer, and forming a first oxidation barrier layer between, and abutting, the Si02 layer and the superconducting material layer.

In this regard, the term "layer", as used throughout the description and the claims, particularly refers to a structure which is formed by a homogeneous material, wherein a thickness of the structure is small compared to a length and a width of the structure (e.g., the length and/or width of the structure may be more than 10 times, more than 100 times, or more than 1000 times larger than its thickness). Moreover, the structure may have a uniform thickness and/or an even surface. Furthermore, the structure may separate two other substantially homogeneous materials (which sandwich the structure).

In this regard, the term "oxide layer", as used throughout the description and the claims, particularly refers to a layer formed by a homogeneous material containing an oxide. For example, the first oxide layer may be formed by $SiO_2$. The thickness of the first oxide layer may roughly correspond to a fourth of an effective wavelength ($\lambda/4$) of electromagnetic radiation, which the photon detector is designed to detect (e.g., infrared radiation), within the first oxide layer. For example, the thickness of the first oxide layer may be between 100 nanometers (nm) and 300 nm or, preferably, between 120 nm and 240 nm. The first oxide layer may be formed via sputter deposition (e.g., radio frequency, RF, sputtering).

Moreover, the term "superconducting material layer", as used throughout the description and the claims, particularly refers to a layer formed by a superconducting material. The superconducting material may comprise Nb. For example, the superconducting material layer may comprise, or be formed by, NbN or NbTiN. Or, the superconducting material may comprise Si. For example, the superconducting material layer may comprise, or be formed by, MoSi or WSi. Alternatively, the superconducting material layer may comprise, or be formed by TaN. The thickness of the superconducting material layer may be less than 100 nm. For example, the thickness of the superconducting material layer may be between 1 nm and 20 nm or, preferably, between 6 nm and 10 nm.

Furthermore, the term "oxidation barrier layer", as used throughout the description and the claims, particularly refers to a layer formed by a material which inhibits the migration of oxygen from the first oxide layer to the superconducting material layer. For example, the first oxidation barrier layer may be formed by $AlO_x$ or AlN. The thickness of the first oxidation barrier layer may be below 5 nm or, preferably, below 2.5 nm. For example, the thickness of the first oxidation barrier layer may be about 1 nm. The first oxidation barrier layer may be formed via sputter deposition (e.g., reactive direct current, DC, sputtering) involving an Al target.

In a step preceding the sputter deposition, the Al target may be exposed to an Ar plasma. Heretofore, the Al target may be arranged in the process chamber and the process chamber may be evacuated until a pressure within the process chamber is below $10^{-10}$ bar, below $10^{-11}$ bar, or below $10^{-12}$ bar. Exposing the Al target to Ar plasma may improve the purity of the target by removing impurities and contaminants from (the surface of) the Al target. The sputter deposition may be carried out only after the temperature of the Al target has sufficiently decreased. For example, the sputter deposition may be carried out only after the temperature of the Al target has fallen below 100°C or, preferably, below 50°C.

The superconducting material layer may be sandwiched between the first oxidation barrier layer and a second oxidation barrier layer. In this regard, the term "sandwiched", as used throughout the description and the claims is to be understood, in particular, to refer to an arrangement where the sandwiched material is formed between, and abutting, two layers that sandwich said material. The method may further comprise forming a second oxide layer which is formed above, and which abuts, the second oxidation barrier layer. In other words, the oxide layers may sandwich the layer stack comprising the oxidation barrier layers and the superconducting material layer, wherein each of the oxide layers abuts one of the oxidation barrier layers to inhibit (or at least substantially reduce) oxidation of the superconducting material.

The oxidation barrier layers may have substantially the same thickness and may be formed by substantially the same material. The method may further comprise etching the superconducting material layer, to form a superconducting nanowire. Alternatively, the superconducting nanowire may be formed by means of lithography (electron beam or optical) or nanoimprint. The superconducting nanowire may form a meander. The meander may comprise a plurality of elongated portions. The elongated portions may have substantially parallel longitudinal axes and a substantially constant width. The substantially constant width may be smaller than 1000 nm or, preferably, smaller than 100 nm.

The meander may have a higher density portion occupied by parallel sections of the meander and two lower density portions occupied by U-shaped sections of the meander. The higher density portion may be mirror symmetric to an axis perpendicular to the parallel sections. The U-shaped sections may comprise legs that are, at least in part, parallel to said parallel sections. In this regard, the term "leg", as used throughout the description and the claims, refers to one of the elongated portions of a U-shaped structure which extends from the bend to the open end of the U-shaped structure. The U-shaped section may be mirror symmetric to an axis which divides the U-shaped section in two halves and is parallel to parts of the legs. The width of the legs may be substantially equal and smaller than the width of the bend. The bend may have the shape of a rectangle from which a round portion has been cut out such that the contour of the bend is formed by three straight edges and a concave edge.

For example, the concave edge may have a streamline-shaped geometry that seeks to optimize the current flow to reduce the effect of current crowding. For a fill factor of 33%, the shape of the concave edge may be determined based on one of the following formulas:

- 
$$x(y) = (a/\pi)\ln[2\cos(\pi y/a)],$$

- 
$$y(x) = \pm(a/\pi)\cos^{-1}[\exp(\pi x/a)/2].$$

Therein, x and y represent the coordinates of individual points defining the concave edge and a is the width of the nanowire. Similar adjustments can be made for higher fill factors.

Both of the lower density portions may be mirror symmetric to axes parallel to the parallel sections. The lower density portions may provide for a stepped or rectangular contour of the meander. The size of the steps of the stepped contour may be uniform and the steps may be uniformly distributed along the outline of the meander. The stepped contour may be V-shaped or comprise V-shaped portions. The V-shaped portions may point at, or away from, the higher density portion.

The U-shaped section may comprise a first leg and a second leg, wherein the first leg tapers inwardly towards an open end of the U-shaped section. An inwardly tapering section may connect a part of the first leg to a section of the superconducting nanowire that is parallel to said part. The inwardly tapering section may allow nesting the U-shaped sections such that U-shaped sections overlap when projecting the U-shaped sections onto a plane that is perpendicular to the parallel sections forming the higher density portion. Moreover, pairs of U-shaped portions may be arranged so as to form a clasp around one or more U-shaped portions arranged between the U-shaped portions forming the pair.

The superconducting nanowire may also comprise a loop section. The loop section may connect a first straight section of the nanowire to a second straight section of the nanowire. The first straight section and the second straight section of the nanowire may be parallel. The first straight section may connect the loop section to a third straight section. The second straight section may connect the loop section to a fourth straight section. The third straight section and the fourth straight section may be parallel to the first straight section and the second straight section. The lateral displacement between the first straight section and the second straight section may be larger than the lateral displacement between the third straight section and the fourth straight section. The longitudinal displacement between the first straight section and the second straight section may be zero. The longitudinal displacement between the third straight section and the fourth straight section may also be zero.

The method may further comprise forming a reflective layer, wherein the first oxide layer is formed above, and abutting, the reflective layer. In this regard, the formulation "formed above", as used throughout the description and the claims, is to define an order of the layers from a bottommost layer which may be closest to a substrate and a topmost layer which may form a surface of the processed article. The reflective layer may be made of Au, Ag, Al, etc. The thickness of the reflective layer may be between 10 nm and 100 nm or, preferably, between 25 nm and 75 nm (e.g., 50 nm). The reflective layer may comprise a distributed Bragg reflector. The reflective layer may be deposited on a surface of the substrate. The substrate may comprise Si. The surface of the substrate may be formed by an oxide top layer (e.g., $Si/SiO_2$ wafer). The substrate may have a low surface roughness. For example, the Root-Mean-Square (RMS) Roughness of the surface may be below 1nm or, preferably, below 0.5nm.

The method may further comprise forming an anti-reflective layer, wherein the anti-reflective layer is formed above, and abutting, the second oxide layer. The anti-reflective layer may comprise Al. For example, the anti-reflective layer may be formed from AlN. The anti-reflective layer may be configured to let photons pass (from outside the layer stack) towards the superconducting material layer but reflect photons which travel from the superconducting material layer towards the anti-reflective layer. The anti-reflective layer may be semitransparent.

The photon detector comprises a first oxide layer, a superconducting nanowire, and a first oxidation barrier between, and abutting, the first oxide layer and the superconducting nanowire.

The superconducting nanowire may comprise Nb, NbN, or, preferably, NbTiN. The superconducting nanowire may also comprise MoSi, WSi, or TaN.

The first oxidation barrier may comprise a material selected from the group consisting of AlOx and AlN.

A thickness of the first oxidation barrier may be below 5 nm or, preferably, below 2.5 nm.

The superconducting nanowire may be sandwiched between the first oxidation barrier and a second oxidation barrier. Both of said oxidation barriers may have substantially the same thickness and be formed by substantially the same material.

The photon detector may further comprise a reflective layer, wherein the first oxide layer may be formed above, and abutting, the reflective layer. The reflective layer may be made of Au. The thickness of the reflective layer may be between 10 nm and 100 nm or, preferably, between 25 nm and 75 nm (e.g., 50 nm).

The photon detector may further comprise a second oxide layer which is formed above, and which abuts, the second oxidation barrier layer.

The superconducting nanowire may form a meander having a higher density portion occupied by parallel sections of the meander and two lower density portions occupied by U-shaped sections of the meander, wherein the U-shaped sections comprise legs that are, at least in part, parallel to said parallel sections. The higher density portion may be mirror symmetric to an axis perpendicular to the parallel sections and the lower density portions may provide for a stepped or rectangular contour of the meander as described above.

The U-shaped section may have a first leg and a second leg, wherein the first leg tapers inwardly towards an open end of the U-shaped section. An inwardly tapering section may connect a part of the first leg to a section of the superconducting nanowire that is parallel to said part.

As described above, the superconducting nanowire may comprise a loop section. The loop section may connect a first straight section of the nanowire to a second straight section of the nanowire. The first straight section and the second straight section of the nanowire may be parallel. The first straight section may connect the loop section to a third straight section. The second straight section may connect the loop section to a fourth straight section. The third straight section and the fourth straight section may be parallel to the first straight section and the second straight section. The lateral displacement between the first straight section and the second straight section may be larger than the lateral displacement between the third straight section and the fourth straight section. The longitudinal displacement between the first straight section and the second straight section may be zero. the longitudinal displacement between the third straight section and the fourth straight section may also be zero.

The photon detector may further comprise an anti-reflective layer. The anti-reflective layer may be formed above, and abut, the second oxide layer. The anti-reflective layer may comprise Al. For example, the anti-reflective layer may be formed by AlN.

The photon detector may further comprise a waveguide which may be connected to the anti-reflective layer. Moreover, the superconducting nanowire may be connected to circuitry which is configured to sense an increase in electrical resistance of the nanowire and the layer stack may be placed in a cooling device such as a cryocooler. The cryocooler may be configured to cool the superconducting nanowire to below 11 K.

Notably, the features of the detector may be features of the method and vice versa.

The conducting wire may form a meander as described above in regard to the superconducting nanowire.

BRIEF DESCRIPTION OF THE DRAWINGS

The foregoing aspects and many of the attendant advantages will become more readily appreciated as the same become better understood by reference to the following description of embodiments, when taken in conjunction with the accompanying drawings, wherein like reference numerals refer to like parts throughout the various views, unless otherwise specified.

Fig. 1 schematically illustrates a substrate on or above which the functional layers are deposited throughout the process;

Fig. 2 schematically illustrates forming a reflective layer on the substrate;

Fig. 3 schematically illustrates forming an oxide layer on the reflective layer;

Fig. 4 schematically illustrates forming an oxidation barrier layer on the oxide layer;

Fig. 5 illustrates aspects of forming the oxidation barrier layer on the oxide layer by sputter deposition of a thin $AlO_x$ and AlN layer on the oxide layer;

Fig. 6 schematically illustrates forming a superconducting material layer on the oxidation barrier layer;

Fig. 7 shows a diagram which illustrates the impact of the oxidation barrier layer thickness on the transition temperature of the superconducting material;

Fig. 8 schematically illustrates patterning the superconducting material layer;

Fig. 9 schematically illustrates a superconducting nanowire formed in the patterned superconducting material layer;

Fig. 10 schematically illustrates forming an oxidation barrier layer on the patterned superconducting material layer;

Fig. 11 schematically illustrates forming an oxide layer on the oxidation barrier layer;

Fig. 12 schematically illustrates forming an anti-reflective layer on the oxide layer;

Fig. 13 schematically illustrates an exemplary photon detector;

Fig. 14 shows a flow chart of steps of a process of manufacturing the exemplary photon detector;

Fig. 15 schematically illustrates a first example of a conducting wire formed by patterning the superconducting material layer;

Fig. 16 schematically illustrates a second example of a conducting wire formed by patterning the superconducting material layer;

Fig. 17 schematically illustrates a third example of a conducting wire formed by patterning the superconducting material layer;

Fig. 18 schematically illustrates a fourth example of a conducting wire formed by patterning the superconducting material layer;

Fig. 19 schematically illustrates a fifth example of a conducting wire formed by patterning the superconducting material layer;

Fig. 20 illustrates the design of a U-shaped structure according to a sixth example; and

Fig. 21 illustrates the design of U-shaped structures according to a seventh example.

Notably, the drawings are not necessarily drawn to scale and unless otherwise indicated, they are merely intended to conceptually illustrate the structures and procedures described herein.

DESCRIPTION OF EMBODIMENTS

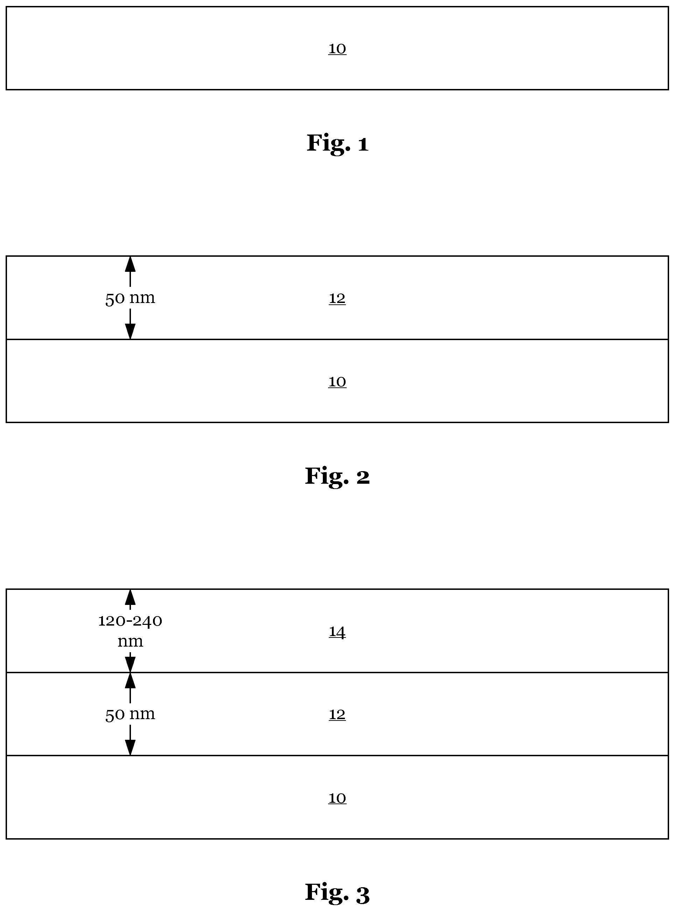

Fig. 1 schematically illustrates substrate 10 on, or above, which the functional layers are deposited throughout the process. The substrate may be a $Si/SiO_2$ wafer. In a first step, a reflective layer 12 may be deposited on the substrate 10 via vapor deposition, as schematically illustrated in Fig. 2. The reflective layer 12 may be made from a metal such as Au, Ag, Al, etc. The thickness of the reflective layer 12 may be between 10 nm and 100 nm or, preferably, between 25 nm and 75 nm (e.g., 50 nm as illustrated in Fig. 2). Furthermore, the reflective layer 12 may comprise multiple sublayers forming a distributed Bragg reflector.

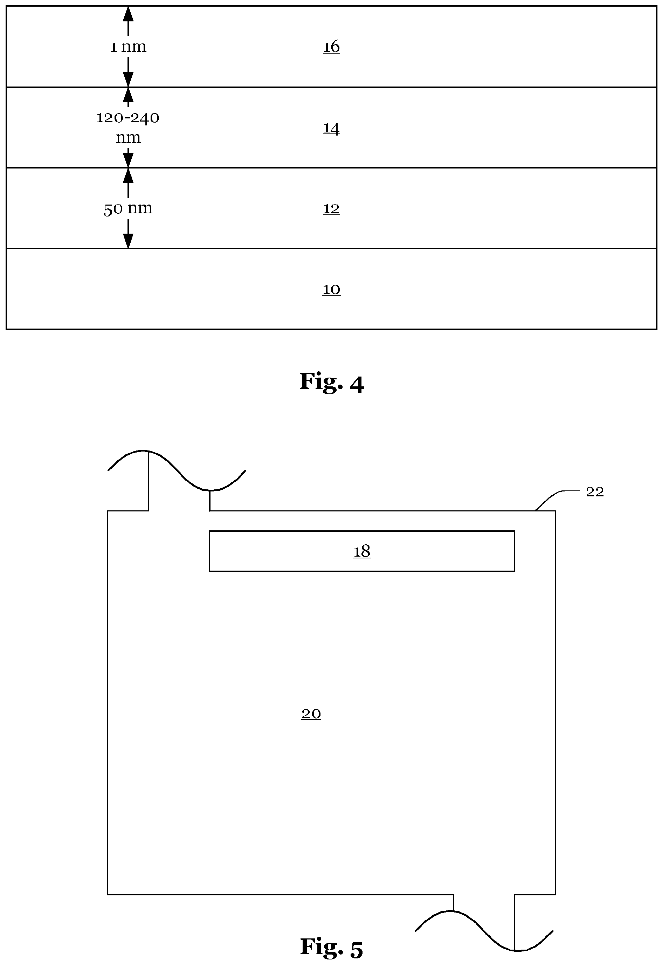

In a second step, an oxide layer 14 may be deposited on the reflective layer 12 via RF sputter deposition, as schematically illustrated in Fig. 3. The thickness of the oxide layer 14 may be between 100 nm and 300 nm or, preferably, between 120 nm and 240 nm as illustrated in Fig. 3. In a third step, an oxidation barrier layer 16 may be deposited on the oxide layer 14 via sputter deposition, as schematically illustrated in Fig. 4. The oxidation barrier layer 16 may comprise Al. For example, the oxidation barrier layer 16 may be formed by $AlO_x$ or AlN. The thickness of the oxidation barrier layer 16 may be below 5 nm or, preferably, below 2.5 nm (e.g., 1 nm as illustrated in Fig. 4).

In a step preceding the sputter deposition, the Al target 18 may be exposed to Ar plasma 20 as schematically illustrated in Fig. 5. In this step, the Al target 18 may be arranged in process chamber 22 and process chamber 22 may be evacuated until the pressure within process chamber 22 is below $10^{-11}$ bar, or, preferably, below $10^{-12}$ bar. After exposing the Al target 18 to Ar plasma 20, the Al target 18 may be brought to about room temperature before commencing the next step.

If the oxidation barrier layer 16 is formed by $AlO_x$, the next step may start with adding Ar to the process chamber 22 until a pressure within process chamber 22 is somewhere between $10^{-4}$ and $10^{-7}$ bar, e.g., around $10^{-5}$ bar and commencing a sputter deposition process involving the Al target 18. A growth rate of the sputter deposition process may be set to about 0.2-0.6 nm/s. If the Al target 18 is a three-inch target, this may be achieved by setting a distance between the target 18 and the oxide layer 14 to between 50 millimeters (mm) and 80 mm and by setting a power involved in the sputter deposition process to between 120 watts and 130 watts. Subsequently, the Al layer formed by the sputter deposition may be oxidized to form an $AlO_x$ layer. Oxidation may be achieved by exposing the Al layer to air for 3 to 8 minutes, e.g., 5 minutes.

If the oxidation barrier layer 16 is formed by AlN, the next step may start with adding Ar to the process chamber 22 until a pressure within process chamber 22 is somewhere between $10^{-4}$ and $10^{-7}$ bar, e.g., around $10^{-5}$ bar and commencing a sputter deposition process involving the Al target 18, Ar (10 standard cubic centimeters per minute, sccm), and $N_2$ (2.5 sccm). A growth rate of the sputter deposition process may be set to about 0.05-0.15 nm/s. If the Al target 18 is a three-inch target, this may be achieved by setting a distance between the target 18 and the oxide layer 14 to between 30 mm and 50 mm and by setting a power involved in the sputter deposition process to between 60 watts and 80 watts.

Notably, the layer stack on the substrate 10 may remain in process chamber 22 as no oxidation involving ambient air is required, thus avoiding the exposition of the layer stack to (potentially degrading) ambient conditions.

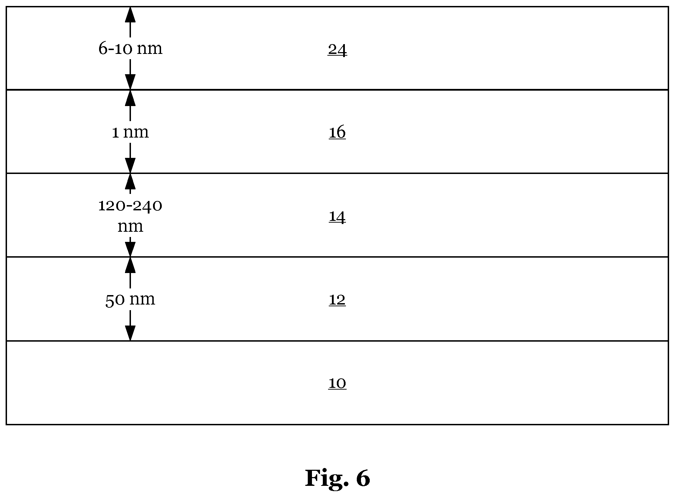

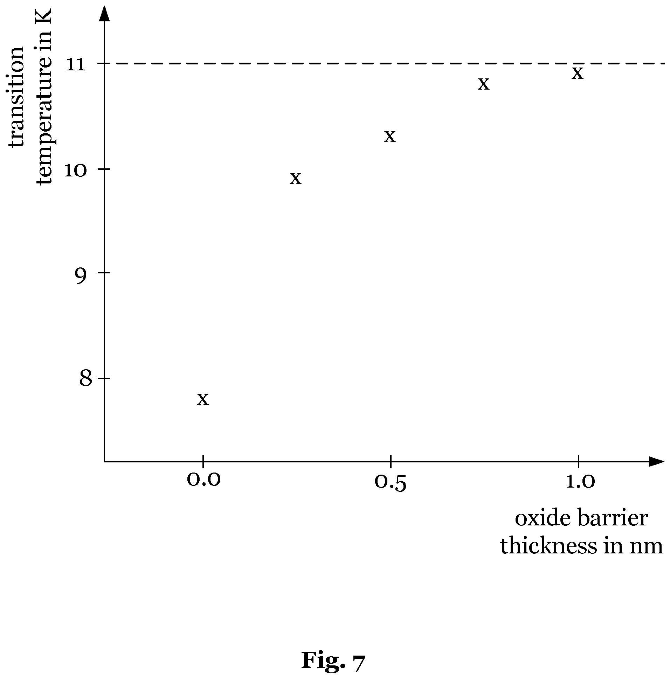

In a fourth step, a superconducting material layer 24 may be deposited on the oxidation barrier layer 16 via reactive DC sputter deposition, as schematically illustrated in Fig. 6. The superconducting material layer 24 may be formed by NbTiN. The thickness of the superconducting material layer 24 may be less than 100 nm, for example, between 1 nm and 20 nm or, preferably, between 6 nm and 10 nm as illustrated in Fig. 6. As illustrated in Fig. 7, the oxidation barrier layer 16 may prevent a drop in transition temperature of the superconducting material that might otherwise occur if the superconducting material layer 24 was deposited (directly) on oxide layer 14 (which has been formed via RF sputter deposition). In other words, oxidation barrier layer 16 may permit forming oxide layer 14 via RF sputter deposition without subjecting superconducting material in the superconducting material layer 24 to a drop in transition temperature due to oxidation.

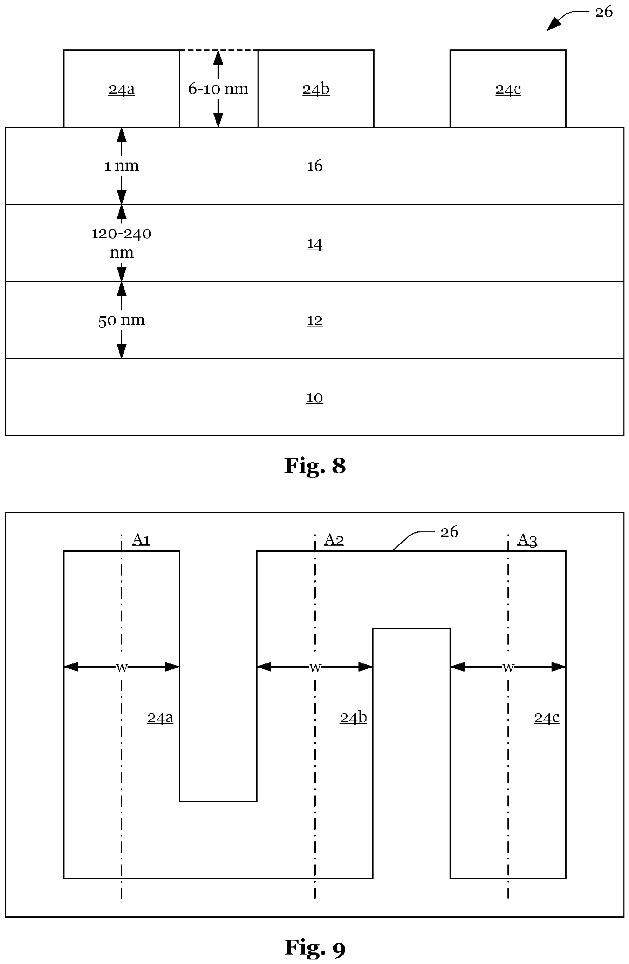

In a fifth step, superconducting material layer 24 may be patterned to form superconducting nanowire 26, as schematically illustrated in Fig. 8 and Fig. 9. Patterning the superconducting material layer 24 may comprise etching the superconducting material layer 24 to form superconducting nanowire 26. The etching may involve an $SF_6$-based etching process that may or may not (as illustrated in Fig. 8) aim at etching through oxidation barrier layer 16. As illustrated in Fig. 9, the superconducting nanowire 26 may form a meander which comprises a plurality of elongated portions 24a, 24b, and 24c. The elongated portions 24a, 24b, and 24c may have substantially parallel longitudinal axes A1, A2, and A3 and a substantially constant width w. Said width w may be smaller than 1000 nm or, preferably, smaller than 100 nm. Moreover, said width w may be larger than 1 nm. For example, the width w of the elongated portions 24a, 24b, and 24c of the superconducting nanowire 26 may be between 25 nm and 200 nm or between 1 nm and 100 nm.

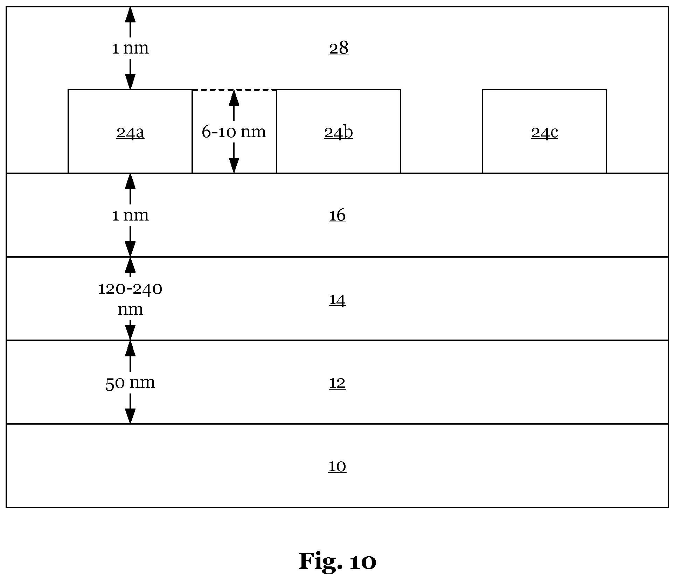

In a sixth step, oxidation barrier layer 28 may be deposited on the patterned superconducting material layer 24 via sputter deposition, as schematically illustrated in Fig. 10. The oxidation barrier layer 28 may comprise Al. For example, the oxidation barrier layer 28 may be formed by $AlO_x$ or AlN. The thickness of the oxidation barrier layer 28 may be below 5 nm or, preferably, below 2.5 nm (e.g., 1 nm as illustrated in Fig. 10).

In a step preceding the sputter deposition, the Al target 18 may again be exposed to Ar plasma 20 as schematically illustrated in Fig. 5. In this step, the Al target 18 may be arranged in the process chamber 22 and the process chamber 22 may be evacuated until the pressure within the process chamber 22 is below $10^{-11}$ bar, or, preferably, below $10^{-12}$ bar. After exposing the Al target 18 to Ar plasma 20, the Al target 18 may be brought to about room temperature before commencing the next step.

If the oxidation barrier layer 28 is formed by $AlO_x$, the next step may start with adding Ar to the process chamber 22 until a pressure within the process chamber 22 is somewhere between $10^{-4}$ and $10^{-7}$ bar, e.g., around $10^{-5}$ bar and commencing a sputter deposition process involving the Al target 18. A growth rate of the sputter deposition process may be set to about 0.2-0.6 nm/s. If the Al target 18 is a three-inch target, this may be achieved by setting a distance between the target 18 and the patterned superconducting material layer 24 to between 50 millimeters (mm) and 80 mm and by setting a power involved in the sputter deposition process to between 120 watts and 130 watts. Subsequently, the Al layer formed by the sputter deposition may be oxidized to form an $AlO_x$ layer. Oxidation may be achieved by exposing the Al layer to air for 3 to 8 minutes, e.g., 5 minutes.

If the oxidation barrier layer 26 is formed by AlN, the next step may start with adding Ar to the process chamber 22 until a pressure within the process chamber 22 is somewhere between $10^{-4}$ and $10^{-7}$ bar, e.g., around $10^{-5}$ bar and commencing a sputter deposition process involving the Al target 18, Ar (10 standard cubic centimeters per minute, sccm), and N2 (2.5 sccm). A growth rate of the sputter deposition process may be set to about 0.05-0.15 nm/s. If the Al target 18 is a three-inch target, this may be achieved by setting a distance between the target 18 and the oxide layer 14 to between 30 mm and 50 mm and by setting a power involved in the sputter deposition process to between 60 watts and 80 watts. Notably, the layer stack on the substrate 10 may remain in the process chamber 22 as no oxidation involving ambient air is required, thus avoiding the exposition of the layer stack to (potentially degrading) ambient conditions.

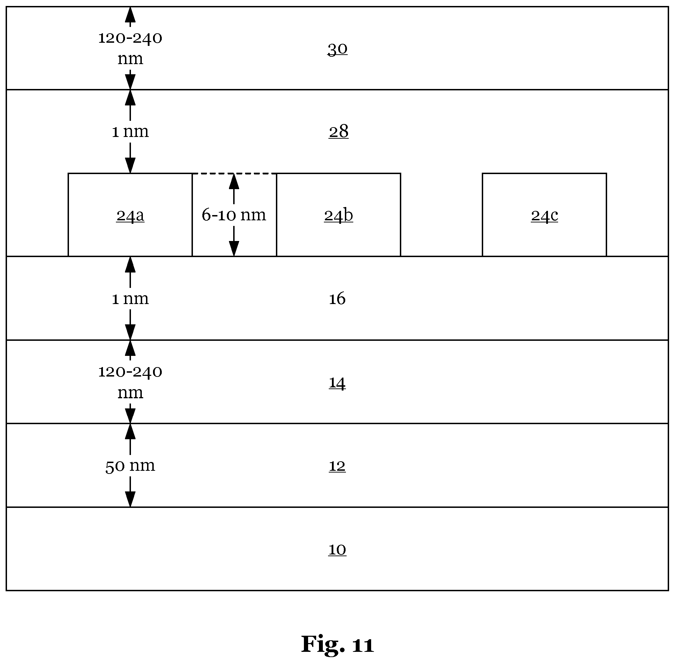

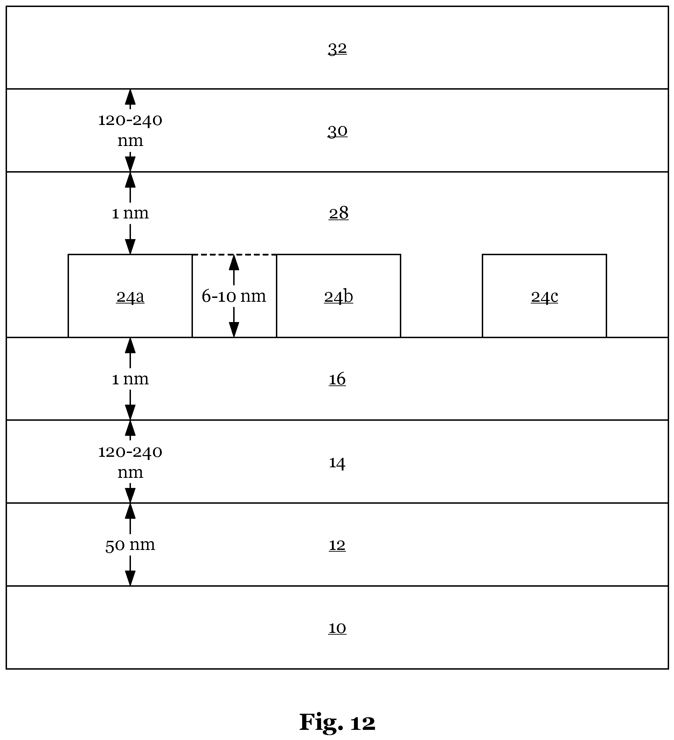

In a seventh step, oxide layer 30 may be deposited on the oxidation barrier layer 28 via RF sputter deposition, as schematically illustrated in Fig. 11. The thickness of the oxide layer 30 may be between 100 nm and 300 nm or, preferably, between 120 nm and 240 nm as illustrated in Fig. 11. In an eighth step, an anti-reflective layer 32 may be deposited on the oxide layer 30 via vapor deposition, as schematically illustrated in Fig. 12. The ant-reflective layer 32 may be made from AlN. In a ninth step, a waveguide 34 may be connected to the anti-reflective layer 32, the superconducting nanowire 26 may be connected to circuitry 36 which is configured to sense an increase in electrical resistance of the nanowire 26 and the layer stack 38 may be placed in a cooling device 40 (such as a cryocooler) to form photon detector 42 (which may be configured to constitute a superconducting nanowire single-photon detector).

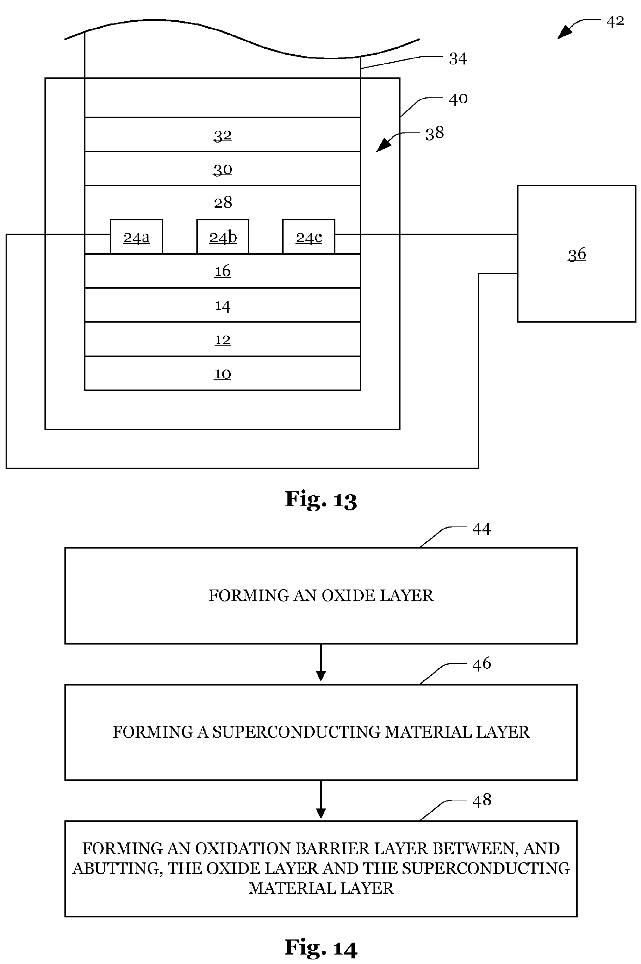

Fig. 14 shows a flow chart of steps of the process of manufacturing the photon detector 42. The process involves step 44 of forming oxide layer 14, step 46 of forming superconducting material layer 24, and step 48 of forming oxidation barrier layer 16 between, and abutting, oxide layer 14 and superconducting material layer 24.

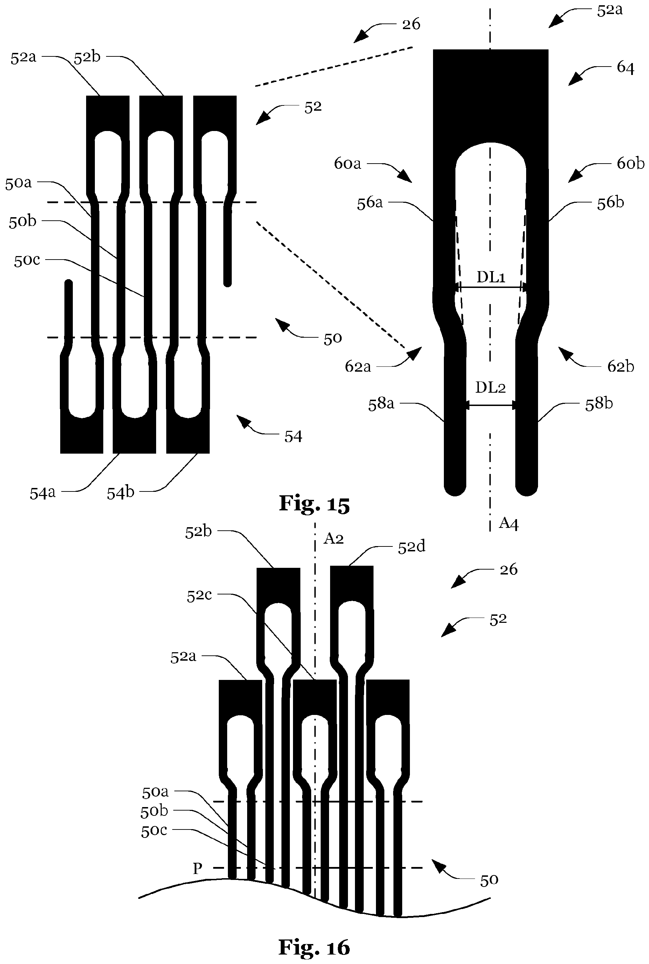

An example of a superconducting nanowire 26 formed in the superconducting material layer 24 is schematically illustrated in Fig. 15. Therein, the superconducting nanowire 26 forms a meander. The meander has a central portion 50 which is occupied by parallel sections 50a, 50b, 50c and two peripheral portions 52 and 54 occupied by loop sections 52a, 52b, 54a, and 54b. As shown in Fig. 15, the parallel sections 52a, 52b, 54a, and 54b may be of equal length and a longitudinal displacement between the parallel sections 52a, 52b, 54a, and 54b may be substantially zero.

As shown in the enlarged view depicted in Fig. 15, a first straight section 56a of the nanowire 26 may be connected to a second straight section 56b of the nanowire 26 by a loop section 52a. Although the first straight section 56a and the second straight section 56b of the nanowire 26 may be parallel as shown in Fig. 15, the first straight section 56a and the second straight section 56b of the nanowire 26 may also be non-parallel (e.g., tapering inwardly) as schematically illustrated in the enlarged view by broken lines.

As shown in Fig. 15, the first straight section 56a may connect the loop section 52a to a third straight section 58a and the second straight section 56b may connect the loop section 52a to a fourth straight section 58b. The third straight section 58a and the fourth straight section 58b may be parallel to the first straight section 56a and the second straight section 56b. The lateral displacement DL1 between the first straight section 56a and the second straight section 56b may be larger than the lateral displacement DL2 between the third straight section 58a and the fourth straight section 58b. Moreover, the longitudinal displacement between the first straight section 56a and the second straight section 56b and the longitudinal displacement between the third straight section 58a and the fourth straight section 58b may both be (substantially) zero.

If the first straight section 56a and the second straight section 56b of the nanowire 26 are parallel (as depicted in Fig. 15), the loop section 52a and the straight sections 56a and 56b may form part of a U-shaped section (of the nanowire 26) which comprises a first leg 60a and a second leg 60b. The legs 60a and 60b may be elongated portions of a U-shaped structure and extend from the bend 64 to the open end of the U-shaped structure. As shown in Fig. 15, the U-shaped section may be mirror symmetric to an axis A4 which divides the U-shaped section in two halves and is parallel to parts of the legs 60a and 60b. The width of the legs 60a and 60b may be substantially equal and smaller than the width of the bend 64. As shown in Fig. 15, the bend 64 may have the shape of a rectangle from which a round portion has been cut out such that the contour of the bend 64 is formed by three straight edges and a concave edge.

For example, the concave edge may have a streamline-shaped geometry that seeks to optimize the current flow to reduce the effect of current crowding. For a fill factor of 33%, the shape of the concave edge may be determined based on one of the following formulas:

• 

$$x(y) = (a/\pi) \ln[2 \cos(\pi y/a)],$$

• 

$$y(x) = \pm(a/\pi) \cos^{-1}[\exp(\pi x/a)/2].$$

Therein, x and y represent the coordinates of individual points defining the concave edge and a is the width of the nanowire. Similar adjustments can be made for higher fill factors.

The legs 60a and 60b may taper inwardly towards an open end of the U-shaped section. At the open end, an inwardly tapering section 62a may connect a straight part of the leg 60a to a straight section 58a of the superconducting nanowire 26 which is parallel to said part. Likewise, an inwardly tapering section 62b may connect a straight part of the leg 60b to a straight section 58b of the superconducting nanowire 26 which is parallel to said part. As illustrated in Fig. 16, the inwardly tapering sections 62a and 62b may allow for nesting the U-shaped sections such that U-shaped sections overlap when projecting the U-shaped sections onto a plane P which is perpendicular to the parallel sections 50a, 50b, and 50c.

Moreover, a pair of U-shaped sections may be arranged to form a (mirror-symmetric) clasp around a U-shaped section which is arranged between the U-shaped sections that form the pair. This may allow for reducing the lateral distance between the parallel sections 50a, 50b, and 50c in the central portion 50 such that the central portion 50 may form a higher density portion 50 (compared to the peripheral portion 52). I.e., the meander may have a higher density portion 50 occupied by the parallel sections 50a, 50b, and 50c of the meander and two lower density portions 52 and 54 (not shown in Fig. 16) occupied by the U-shaped sections of the meander, wherein the U-shaped sections comprise legs 60a and 60b that are, for the most part, parallel to said parallel sections 50a, 50b, and 50c. The fill factor of a higher density portion 50 according to the design illustrated by Fig. 16 may be about 50%.

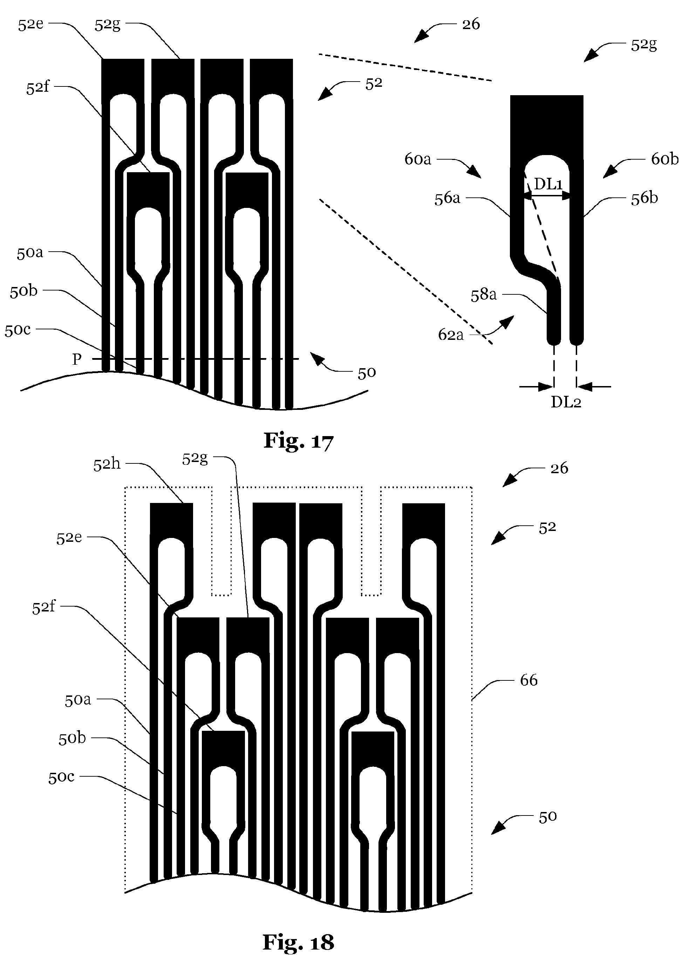

To increase the fill factor, the meander may also comprise U-shaped sections which have only one leg 60a that tapers inwardly. As shown in the enlarged view depicted in Fig. 17, loop section 52g may connect a first straight section 56a of the nanowire 26 to a second straight section 56b of the nanowire 26, wherein the first straight section 56a and the second straight section 56b are parallel. Notably, the first straight section 56a and the second straight section 56b of the nanowire 26 may also be non-parallel (e.g., the first straight section 56a may taper inwardly) as schematically illustrated in the enlarged view by the broken line. As shown in Fig. 17, the first straight section 56a may connect the loop section 52g to a third straight section 58a. The third straight section 58a may be parallel to the first straight section 56a and the second straight section 56b. The lateral displacement DL1 between the first straight section 56a and the second straight section 56b may be larger than the lateral displacement DL2 between the third straight section 58a and the second straight section 56b.

If the first straight section 56a and the second straight section 56b of the nanowire 26 are parallel (as shown in Fig. 17), the loop section 52a and the straight sections 56a and 56b may form part of a U-shaped section which comprises a first leg 60a and a second leg 60b. The first leg 60a may taper inwardly towards an open end of the U-shaped section. At the open end, the inwardly tapering section 62a may connect a straight part of the leg 60a to a straight section 58a of the superconducting nanowire 26 which is parallel to said part.

As illustrated in Fig. 17, the inwardly tapering sections 62a of two-mirror-symmetrically arranged U-shaped sections allow for nesting U-shaped sections such that there is an even greater overlap when projecting the U-shaped sections onto plane P. For instance, the fill factor of a higher density portion 50 in accordance with the design illustrated in Fig. 17 may be about 60%. A further increase to a fill factor of about 80% may be possible by adopting the design illustrated in Fig. 18 where a symmetric U-shaped portion is arranged between an inner clasp and an outer clasp. As shown in Fig. 18, the inner clasp may comprise two asymmetric U-shaped sections surrounding the symmetric U-shaped portion. The outer clasp may comprise two asymmetric U-shaped sections surrounding the inner clasp. Moreover, the design may be further modified by adding further clasp levels in order to achieve a further increase regarding the fill factor.

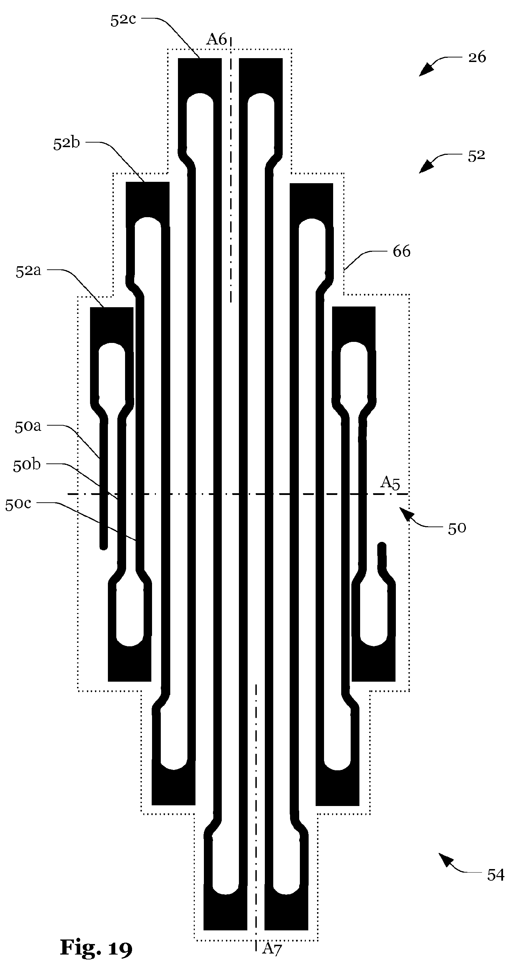

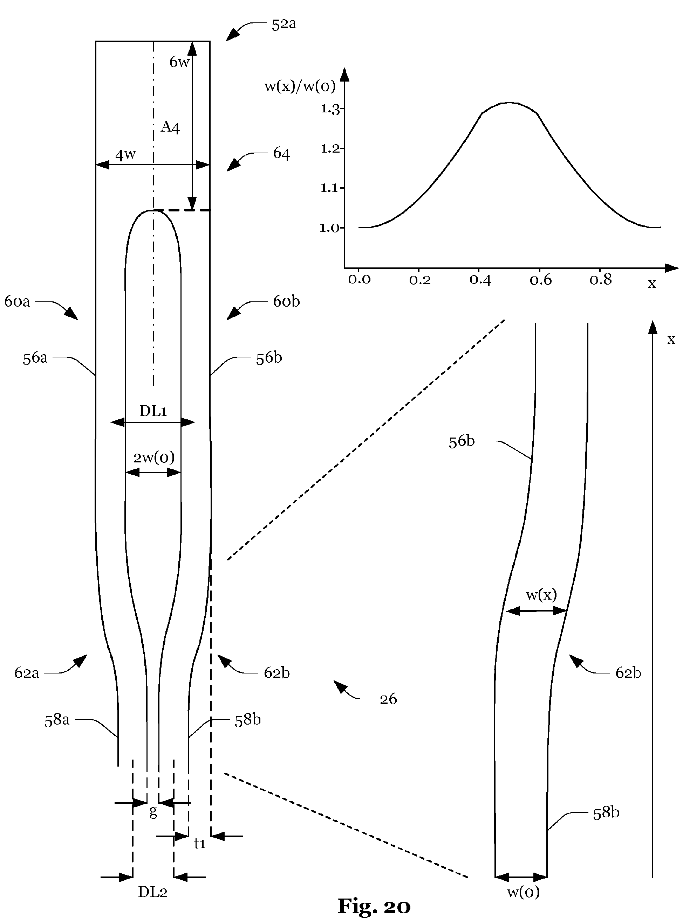

As illustrated in Fig. 19, the higher density portion 50 may be mirror symmetric to an axis A5 which is perpendicular to the parallel sections 50a, 50b, and 50c while the lower density portions 52 and 54 may be mirror symmetric to axes A6 and A7, respectively, which are parallel to the parallel sections 50a, 50b, and 50c. Moreover, as illustrated in Fig. 18 and Fig. 19, the lower density portions may provide for a rectangular or stepped contour 66 of the meander. As illustrated in Fig. 19, the size of the steps of the stepped contour 66 may be uniform and the steps may be uniformly distributed along the outline of the meander. As illustrated by Fig. 18 and Fig. 19, the stepped contour may be V-shaped or comprise V-shaped portions. The V-shaped portions may point at, or away from, the higher density portion 50. Fig. 20 illustrates a symmetric U-shaped section of a nanowire 26 which comprises legs 60a and 60b that delimit a free space having a needle-eye shape. The width g of the gap between the parallel sections 58a and 58b and the width ti of the taper of the inwardly tapering sections 62a and 62b may be calculated based on the width w(0) of the nanowire 26 and the desired fill factor ff as follows:

- g=w(o)/ff-w(o); and

- $t_1$=w(o)-g/2.

The edges of the inwardly tapering sections may comprise a well-defined streamline course that allows for the widening of the nanowire without introducing current crowding.

The streamline course may be used to introduce a lateral shift in the course of the nanowire (which generally extends in the longitudinal direction) without introducing current crowding effects. The streamline course can be determined as follows. First, it is assumed that outside of the streamline course the nanowire has a width of $2w_1$. Second, it is assumed that (on one side of the streamline course) the nanowire is centered around the y-axis and (the end of the streamline course connected to said side) starts at x = 0. Along the streamline course, the nanowire has a width of $2w_2 = 2(w_1 + t_1)$.

The procedure starts with mapping the coordinate system onto a complex space using a conformal mapping, which allows introducing complex parameters describing the sheet current density throughout the nanowire. With these parameters representing the sheet current density the contours corresponding to streamlines of the sheet-current density in the nanowire system may be calculated. The desired streamline function is the contour for which there is no current crowding introduced by the nanowire widening. This occurs for the streamline which starts at y = $w_1$ and ends at y = $w_2$. The following procedure is broken down into the main mathematical steps needed to reproduce the structure. Further explanations may be found in Part X.B. of Clem, John R. & Berggren, Karl K., Geometry-dependent critical currents in superconducting nanocircuits, Physical Review B, PRB, 84, 17, 174510.

At the outset, a conformal mapping is introduced with the two parameters y and $\Omega$, where $0 < \varphi < \pi$:

$$\gamma = \frac{(4w_1^2 + 4w_2^2)}{(4w_1^2 - 4w_2^2)}$$

$$\Omega(\varphi) = \cos(\varphi) + i\sin(\varphi)$$

These parameters may then be used to calculate imaginary entities that represent the current sheet density in the nanowire in the new conformal coordinate system:

$$X_1 = 4w_1 \tan^{-1}\left(\frac{\sqrt{\Omega - \gamma}}{\sqrt{\gamma + 1}}\right)$$

$$X_2 = 4w_2 \tan^{-1}\left(\frac{\sqrt{\gamma - 1}}{\sqrt{\Omega - \gamma}}\right)$$

Here, the optimal streamline is represented by the equation:

$$X_\omega = \frac{i}{\pi}(X_1 + X_2)$$

Finally, the coordinates of individual points along the streamline tapering in the normal 2D-coordinate system may be calculated based on the following formulas where $\varphi$ runs from 0 to $\pi$:

$$x(\varphi) = Re\{X_\omega\}$$

$$y(\varphi) = -Im\{X_\omega\}$$

The outer edge of an inwardly tapering section may have the same course as the inner edge and may have a lateral displacement of w(o) or more. Therefore, the inwardly tapering sections 62a and 62b may have a width that is larger than the width of the straight sections 56a, 56b, 58a, and 58b. For example, as shown in Fig. 20, the inwardly tapering sections 62a and 62b may have a width that is more than 20% or even more than 30% larger than the width of the straight sections 56a, 56b, 58a, and 58b. The width-increase of the tapering section 62a, 62b may follow a well-defined path which may be calculated by the afore-mentioned streamline tapering formula, and which depends on the shift ti required to allow for the desired fill factor of the higher density portion.

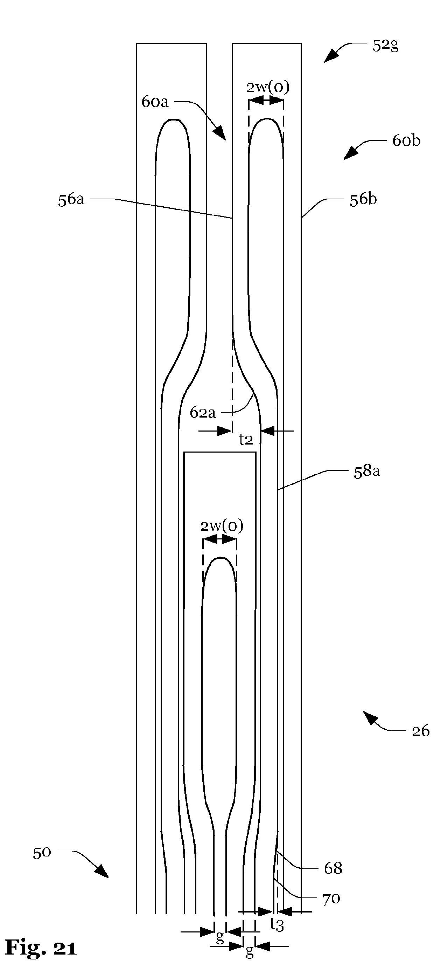

Fig. 21 illustrates a nanowire 26 comprising a pair of asymmetric U-shaped sections which form a (mirror-symmetric) clasp around the U-shaped shown in Fig. 20. Therein, the width t2 of the taper of the inwardly tapering section 62a may be calculated as t2=2w(0)-d, wherein d represents the minimum (lateral) distance between two neighboring nanowire sections. To ensure that there is a uniform gap between the straight parallel sections of the higher density portion 50, there may be an outwardly tapering section 68 which connects straight section 58a to straight section 70. The width t3 of the taper of the outwardly tapering section 68 may be calculated as t3=g-d. Moreover, the outwardly tapering section 68 may have a width that is larger than the width of the straight sections 56a, 56b, 58a, 58b, and 70. For example, the outwardly tapering section 68 may have a width that is more than 10% or even more than 20% larger than the width of the straight sections 56a, 56b, 58a, 58b, and 70. The contour of outwardly tapering section 68 may also be determined based on the afore-mentioned streamline tapering formula.

Furthermore, it is noted that although the meander shape described in the foregoing has been described with respect to a superconducting nanowire 26, the described shape may also be employed in shaping any conducting wire.

REFERENCE SIGNS LIST

| 10 | substrate |
| 12 | reflective layer |
| 14 | oxide layer |
| 16 | oxidation barrier layer |
| 18 | Al target |
| 20 | Ar plasma |
| 22 | process chamber |
| 24 | superconducting material layer |
| 24a | elongated portion (nanowire) |
| 24b | elongated portion (nanowire) |
| 24c | elongated portion (nanowire) |
| 26 | superconducting nanowire |
| 28 | oxidation barrier layer |
| 30 | oxide layer |
| 32 | anti-reflective layer |
| 34 | wave guide |
| 36 | circuitry |
| 38 | layer stack |
| 40 | cooling device |
| 42 | photon detector |
| 44 | step |
| 46 | step |
| 48 | step |
| 50 | portion |
| 50a | section |
| 50b | section |
| 50c | section |
| 52 | portion |
| 52a | loop section |
| 52b | loop section |
| 52c | loop section |
| 52d | loop section |
| 52e | loop section |
| 52f | loop section |
| 52g | loop section |
| 52h | loop section |
| 54 | portion |
| 54a | loop section |
| 54b | loop section |
| 56a | straight section |
| 56b | straight section |
| 58a | straight section |
| 58b | straight section |
| 60a | leg |
| 60b | leg |
| 62a | section |
| 62b | section |
| 64 | bend |
| 66 | contour |
| 68 | section |
| 70 | section |

**Claims**

1. A method of manufacturing a photon detector, comprising

    forming (44) an oxide layer (14);
    forming (46) a superconducting material layer (24); and
    forming (48) an oxidation barrier layer (16) between, and abutting, the oxide layer (14) and the superconducting material layer (24).

2. The method of claim 1, wherein the superconducting material layer (24) is sandwiched between the oxidation barrier layer (16) and another oxidation barrier layer (28), both of said oxidation barrier layers (16, 28) having substantially the same thickness and being formed by substantially the same material.

3. The method of claim 2, further comprising:
    forming a reflective layer (12), wherein the oxide layer (14) is formed above, and abutting, the reflective layer (12).

4. The method of any one of claims 1 to 3, further comprising:
    forming a superconducting nanowire (26) by means of lithography, nanoimprint, or etching.

5. The method of claim 4, wherein the superconducting nanowire (26) forms a meander having a higher density portion (50) occupied by parallel sections (50a, 50b, 50c) of the meander and two lower density portions (52, 54) occupied by U-shaped sections of the meander, wherein the U-shaped sections comprise legs (60a, 60b) that are, at least in part, parallel to said parallel sections (50a, 50b, 50c).

6. The method of claim 4 or 5, wherein the superconducting nanowire (26) comprises a U-shaped section having a first leg (60a) and a second leg (60b), wherein the first leg (60a) tapers inwardly towards an open end of the U-shaped section.

7. The method of claim 4, wherein the superconducting nanowire (26) comprises a loop section (52a, 52b, 54a, 54b), wherein the loop section (52a, 52b, 54a, 54b) connects a first straight section (56a) of the nanowire (26) to a second straight section (56b) of the nanowire (26), wherein the first straight section (56a) and the second straight section (56b) of the nanowire (26) are parallel, the first straight section (56a) connecting the loop section (52a, 52b, 54a, 54b) to a third straight section (58a) and the second straight section (56b) connecting the loop section (52a, 52b, 54a, 54b) to a fourth straight section (58b), wherein the third straight section (58a) and the fourth straight section (58b) are parallel to the first straight section (56a) and the second straight section (56b) and a lateral displacement between the first straight section (56a) and the second straight section (56b) is larger than a lateral displacement between the third straight section (58a) and the fourth straight section 58b).

8. A photon detector (42), comprising:

    an oxide layer (14);
    a superconducting nanowire (26); and
    an oxidation barrier between, and abutting, the oxide layer (14) and the superconducting nanowire (26).

9. The photon detector (42) of claim 8, wherein the superconducting nanowire (26) is sandwiched between the oxidation barrier and another oxidation barrier, both of said oxidation barriers having substantially the same thickness and being formed by substantially the same material.

10. The photon detector (42) of claim 8 or 9, wherein the superconducting nanowire (26) forms a meander having a higher density portion (50) occupied by parallel sections (50a, 50b, 50c) of the meander and two lower density portions (52, 54) occupied by U-shaped sections of the meander, wherein the U-shaped sections comprise legs (60a, 60b) that are, at least in part, parallel to said parallel sections (50a, 50b, 50c).

11. The photon detector (42) of claim 10, wherein the higher density portion (50) is mirror symmetric to an axis perpendicular to the parallel sections (50a, 50b, 50c) and the lower density portions (52, 54) provide for a stepped or rectangular contour (60) of the meander.

12. The photon detector (42) of claim 8 or 9, wherein the superconducting nanowire (26) comprises a U-shaped section having a first leg (60a) and a second leg (60b), wherein the first leg (60a) tapers inwardly towards an open end of the U-shaped section.

13. The photon detector (42) of claim 12, wherein an inwardly tapering section (62a) connects a part of the first leg (60a) to a section (58a) of the superconducting nanowire (26) that is parallel to said part.

14. The photon detector (42) of claim 8 or 9, wherein the superconducting nanowire (26) comprises a loop section (52a, 52b, 54a, 54b), wherein the loop section (52a, 52b, 54a, 54b) connects a first straight section (56a) of the nanowire (26) to a second straight section (56b) of the nanowire (26), wherein the first straight section (56a) and the second straight section (56b) of the nanowire (26) are parallel, the

**EP 4 304 322 A1**

first straight section (56a) connecting the loop section (52a, 52b, 54a, 54b) to a third straight section (58a) and the second straight section (56b) connecting the loop section (52a, 52b, 54a, 54b) to a fourth straight section (58b), wherein the third straight section (58a) and the fourth straight section (58b) are parallel to the first straight section (56a) and the second straight section (56b), and a lateral displacement between the first straight section (56a) and the second straight section (56b) is larger than a lateral displacement between the third straight section (58a) and the fourth straight section (58b).

15. The photon detector (42) of claim 14, wherein a longitudinal displacement between the first straight section (56a) and the second straight section (56b) is zero and wherein a longitudinal displacement between the third straight section (58a) and the fourth straight section (58b) is zero.

10

**Fig. 1**

50 nm    12

10

**Fig. 2**

120-240 nm    14

50 nm    12

10

**Fig. 3**

1 nm         16

120-240 nm         14

50 nm         12

10

**Fig. 4**

22

18

20

**Fig. 5**

| | | |
|---|---|---|
| 6-10 nm | | 24 |
| 1 nm | | 16 |
| 120-240 nm | | 14 |
| 50 nm | | 12 |
| | | 10 |

**Fig. 6**

**Fig. 7**

**Fig. 8**

**Fig. 9**

**Fig. 10**

120-240
nm | 30

1 nm | 28

24a | 6-10 nm | 24b | 24c

1 nm | 16

120-240
nm | 14

50 nm | 12

10

**Fig. 11**

32

120-240
nm

30

1 nm

28

24a    6-10 nm    24b      24c

1 nm

16

120-240
nm

14

50 nm

12

10

**Fig. 12**

**Fig. 13**

**Fig. 14**

**Fig. 15**

**Fig. 16**

**Fig. 17**

**Fig. 18**

**Fig. 19**

**Fig. 20**

**Fig. 21**

EP 4 304 322 A1

| | Europäisches Patentamt / European Patent Office / Office européen des brevets | **EUROPEAN SEARCH REPORT** | Application Number EP 22 18 3535 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/239519 A1 (YANG ZIHAO [US] ET AL) 5 August 2021 (2021-08-05) | 1-5,8-11 | INV. H10N60/84 |
| A | * paragraph [0031] - paragraph [0049]; figures 4-8B * ----- | 6,7, 12-15 | H10N60/01 G01J1/00 |
| X | RAOUIA RHAZI ET AL: "Improvement of critical temperature of niobium nitride deposited on 8-inch silicon wafers thanks to an AlN buffer layer", SUPERCONDUCTOR SCIENCE AND TECHNOLOGY, IOP PUBLISHING, TECHNO HOUSE, BRISTOL, GB, vol. 34, no. 4, 23 February 2021 (2021-02-23), page 45002, XP020365289, ISSN: 0953-2048, DOI: 10.1088/1361-6668/ABE35E [retrieved on 2021-02-23] | 1,2,4,5, 8,10,11 | ADD. G01J1/44 G01J5/20 |
| A | * page 2, right-hand column, line 9 - page 7, left-hand column, line 3; figures 1-8 * ----- | 6,7, 12-15 | |
| A | CN 111 637 981 A (UNIV TIANJIN) 8 September 2020 (2020-09-08) * figures 1(a), 2(a), 3(a) * ----- | 6,7, 12-15 | TECHNICAL FIELDS SEARCHED (IPC) H10N G01J |
| A | WO 2021/253931 A1 (UNIV NANJING [CN]) 23 December 2021 (2021-12-23) * figures 1,2,12 * ----- | 6,7, 12-15 | |

The present search report has been drawn up for all claims

| Place of search | Date of completion of the search | Examiner |
|---|---|---|
| Munich | 9 January 2023 | Gröger, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P04C01)

26

# EP 4 304 322 A1

## ANNEX TO THE EUROPEAN SEARCH REPORT
## ON EUROPEAN PATENT APPLICATION NO.

EP 22 18 3535

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2023

| Patent document cited in search report | | Publication date | Patent family member(s) | | Publication date |
|---|---|---|---|---|---|
| US 2021239519 | A1 | 05-08-2021 | EP | 4100707 A2 | 14-12-2022 |
| | | | TW | 202136725 A | 01-10-2021 |
| | | | US | 2021239519 A1 | 05-08-2021 |
| | | | WO | 2021216162 A2 | 28-10-2021 |
| CN 111637981 | A | 08-09-2020 | NONE | | |
| WO 2021253931 | A1 | 23-12-2021 | CN | 111721429 A | 29-09-2020 |
| | | | WO | 2021253931 A1 | 23-12-2021 |

EPO FORM P0459

For more details about this annex : see Official Journal of the European Patent Office, No. 12/82

27

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8761848 B2

**Non-patent literature cited in the description**

- **JOHN R. ; BERGGREN, KARL K.** Geometry-dependent critical currents in superconducting nanocircuits. *Physical Review B, PRB,* vol. 84 (17), 174510